(19) Europäisches Patentamt / European Patent Office / Office européen des brevets

(11) **EP 2 784 136 B1**

(12) **EUROPEAN PATENT SPECIFICATION**

(45) Date of publication and mention
of the grant of the patent:
**20.07.2016 Bulletin 2016/29**

(51) Int Cl.:
***C09D 5/00*** *(2006.01)*

(21) Application number: **14155207.5**

(22) Date of filing: **14.02.2014**

(54) **PZT-based ferroelectric thin film-forming composition, method of preparing the same, and method of forming PZT-based ferroelectric thin film using the same**

PZT-basierte dünne ferroelektrische filmbildende Zusammensetzung, Verfahren zu ihrer Herstellung, und Verfahren zur Herstellung eines PZT-basierten ferroelektrischen Dünnfilms damit

Composition de formation de film mince ferroélectrique à base de PTZ, son procédé de préparation, et procédé de formation dudit film mince l'utilisant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.03.2013 JP 2013066421**

(43) Date of publication of application:
**01.10.2014 Bulletin 2014/40**

(73) Proprietor: **Mitsubishi Materials Corporation Chiyoda-ku Tokyo 100-8117 (JP)**

(72) Inventors:
• **Doi, Toshihiro
Naka-shi, Ibaraki (JP)**
• **Sakurai, Hideaki
Naka-shi, Ibaraki (JP)**
• **Soyama, Nobuyuki
Naka-shi, Ibaraki (JP)**

(74) Representative: **Gille Hrabal
Brucknerstrasse 20
40593 Düsseldorf (DE)**

(56) References cited:
**EP-A2- 2 642 510      WO-A1-2006/016729
WO-A2-2008/058121      CN-A- 1 263 070
US-A1- 2005 128 675**

**EP 2 784 136 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

Field of the Invention

The present invention relates to a PZT-based ferroelectric thin film-forming composition, a method of preparing the composition, and a method of forming a PZT-based ferroelectric thin film using the composition. Specifically, the invention relates to a composition used to form a PZT-based ferroelectric thin film, which is used for a dielectric layer or the like of a thin film capacitor, using a sol-gel method; a method of preparing the composition; and a method of forming a PZT-based ferroelectric thin film using the composition. More specifically, the invention relates to a PZT-based ferroelectric thin film-forming composition capable of increasing the thickness of a thin film formed for each coating process without cracking and capable of increasing the production efficiency of a thin film.
Priority is claimed on Japanese Patent Application No. 2013-66421, filed on March 27, 2013, the content of which is incorporated herein by reference.

Description of Related Art

When a ferroelectric thin film is formed using a sol-gel method, typically, a high-temperature process such as pre-baking or baking is performed. Therefore, when an attempt to obtain a thicker film is made by increasing the coating amount in each coating process, tensile stress generated in the film during baking or the like is increased, which may cause a problem of cracking in the formed film.
When cracking occurs in the formed film, the electrical properties or the like of the ferroelectric thin film deteriorate. In the related art, the thickness of a film which can be formed for each coating process using a sol-gel method is limited to about 100 nm. In order to form a thick ferroelectric thin film, a method used to perform coating and baking processes of a composition multiple times is adopted. However, with this method, production efficiency decreases, which leads to an increase in film forming cost. Therefore, studies and developments have been actively made regarding improvement of a material, that is, regarding a raw material solution capable of increasing the thickness of a film formed in each coating process without cracking.
For example, Japanese Unexamined Patent Application, First Publication No. 2001-261338 (claim 1, paragraphs [0015] to [0024], Table 1) discloses a metal oxide thin film-forming raw material solution used to form a Ti-containing metal oxide thin film, in which propylene glycol is added to the raw material solution. Using this raw material solution, a film having a thickness of 0.2 μm or greater can be formed for each coating process without cracking. In addition, disclosed is a method capable of increasing the thickness of a film formed for each coating process without cracking, in which a high-molecular compound is added to a high-concentration sol-gel solution to release tensile stress generated during film formation (for example, refer to J Sol-Gel Sci Technol (2008) 47:316 to 325).

SUMMARY OF THE INVENTION

Technical Problem

In the raw material solutions disclosed in Japanese Unexamined Patent Application, First Publication No. 2001-261338 and J Sol-Gel Sci Technol (2008) 47:316 to 325, cracking can be prevented to some extent by the addition of the propylene glycol and the high-molecular compound; however, in order to form a film having practically sufficient properties, it is necessary that cracking be further suppressed and a film having a dense structure be formed. Therefore, there is a room for further improvement. In addition, due to the addition of the high-molecular compound or the like, there is also a manufacturing problem in that, for example, the baking time is increased as compared to the related art. Therefore, there is also a room for further improvement in simplifying a film-forming process during the formation of a relatively thick film and in reducing cost.
An object of the invention is to provide a PZT-based ferroelectric thin film-forming composition capable of increasing, when a ferroelectric thin film is formed using a sol-gel method, the thickness of a thin film formed for each coating process without cracking and capable of increasing the production efficiency of a thin film; a method of preparing the composition; and a method of forming a PZT-based ferroelectric thin film using the composition.

Solution to Problem

As a result of thorough investigation, the present inventors found that, even when the amount of a high-molecular compound or the like added for preventing cracking is suppressed, the addition effects thereof can be obtained by adding a predetermined amount of water to a composition. Further, it was also found that, with the above-described configuration, both of the simplification and cost reduction of a film-forming process during the formation of a thick film having a small amount of cracks and a dense structure, can be simultaneously achieved, thereby completing the invention.

According to a first aspect of the invention, there is provided a PZT-based ferroelectric thin film-forming composition for forming a PZT-based ferroelectric thin film, the composition including: a PZT precursor; a diol; one of polyvinyl pyrrolidones and a polyethylene glycol; and water, in which a ratio of the PZT precursor in 100 wt% of the composition is 17 wt% to 35 wt% in terms of oxides, a ratio of the diol to 100 wt% of the composition is 16 wt% to 56 wt%, a ratio of the one of the polyvinyl pyrrolidones and the polyethylene glycol to 1 mol of the PZT precursor is 0.01 to 0.25 mol in terms of monomers, a ratio of the water to 1 mol of the PZT precursor is 0.5 to 3 mol, and the composition does not further contain a linear monoalcohol having 6 to 12 carbon chains which has a ratio of 0.6 to 10 wt% with respect to 100 wt% of the composition.

According to a second aspect of the invention, in the composition according to the first aspect, it is preferable that the diol be one of a propylene glycol and an ethylene glycol.

According to a third aspect of the invention, there is provided a method of preparing a PZT-based ferroelectric thin film-forming composition, the method including: a step of mixing a PZT precursor which has a ratio of 17wt% to 35 wt% in terms of oxides with respect to 100 wt% of the composition, and a diol which has a ratio of 16 to 56 wt% with respect to 100 wt% of the composition to react with each other to prepare a synthetic solution; a step of refluxing the synthetic solution at a temperature of 130 to 175°C for 0.5 to 3 hours; a step of cooling the refluxed synthetic solution to 0 to 50°C, adding water, which has a ratio of 0.5 to 3 mol with respect to 1 mol of the PZT precursor, to the synthetic solution, and then re-refluxing the synthetic solution at a temperature of 100 to 175°C for 0.5 to 10 hours; and a step of adding one of polyvinyl pyrrolidones and a polyethylene glycol which has a ratio of 0.01 to 0.25 mol with respect to 1 mol of the PZT precursor, to the re-refluxed synthetic solution to be uniformly dispersed in the synthetic solution.

According to a fourth aspect of the invention, in the method according to the second aspect, it is preferable that the diol be one of a propylene glycol and an ethylene glycol.

According to a fifth aspect of the invention, there is provided a method of forming a PZT-based ferroelectric thin film, the method including: coating the PZT-based ferroelectric thin film-forming composition according to the first or second aspect or a PZT-based ferroelectric thin film-forming composition prepared using the method according to the third or fourth aspect on a lower electrode of a substrate; pre-baking the composition; and baking the composition to be crystallized and to form a thin film on the lower electrode.

According to a sixth aspect of the invention, there is provided a complex electronic component including: a PZT-based ferroelectric thin film which is formed using the method according to the fifth aspect, in which the complex electronic component is one of a thin film capacitor, a capacitor, an IPD, a DRAM memory capacitor, a laminated capacitor, a gate insulator of a transistor, a non-volatile memory, a pyroelectric infrared detecting element, a piezoelectric element, an electro-optic element, an actuator, a resonator, an ultrasonic motor, an electric switch, an optical switch, and an LC noise filter element.

Advantageous Effects of Invention

The PZT-based ferroelectric thin film-forming composition according to the first aspect of the invention includes: a PZT precursor; a diol; one of polyvinyl pyrrolidones and a polyethylene glycol; and water, in which a ratio of the PZT precursor to 100 wt% of the composition is 17 wt% to 35 wt% in terms of oxides, and a ratio of the diol to 100 wt% of the composition is 16 wt% to 56 wt%. In addition, a ratio of the one of the polyvinyl pyrrolidones and the polyethylene glycol to 1 mol of the PZT precursor is 0.01 to 0.25 mol in terms of monomers, and a ratio of the water to 1 mol of the PZT precursor is 0.5 to 3 mol. As a result, in a case where this composition is used for forming a ferroelectric thin film with a sol-gel method, a ferroelectric thin film having an extremely small amount of cracks and superior electrical properties can be formed even when the thickness of a thin film formed in each coating process is greater than or equal to several hundreds of nanometers. Further, since the amount of the one of the polyvinyl pyrrolidones and the polyethylene glycol is relatively small, a high-temperature process during film formation can be simplified, and production efficiency can be improved. In addition, an effect of reducing the residual stress of a film can be obtained. In addition, since this composition contains the diol, an effect of improving storage stability can be obtained. Further, since this composition contains water, hydrolysis is appropriately promoted, and decomposition is likely to occur during film formation. Therefore, it is difficult for pores to be formed in a film, and an effect of improving film density can be obtained.

The PZT-based ferroelectric thin film-forming composition according to the second aspect of the invention contains one of a propylene glycol and an ethylene glycol as the diol and thus is superior in storage stability and the formation of a thick film.

The method of preparing a PZT-based ferroelectric thin film-forming composition according to the third aspect of the invention includes: a step of mixing a PZT precursor which has a ratio of 17 to 35 wt% in terms of oxides with respect to 100 wt% of the composition, and a diol which has a ratio of 16 to 56 wt% with respect to 100 wt% of the composition to react with each other to prepare a synthetic solution; a step of refluxing the synthetic solution at a temperature of 130 to 175°C for 0.5 to 3 hours; a step of cooling the refluxed synthetic solution to 0 to 50°C, adding water, which has a ratio of 0.5 to 3 mol with respect to 1 mol of the PZT precursor, to the synthetic solution, and re-refluxing the synthetic solution at a temperature of 100 to 175°C for 0.5 to 10 hours; and a step of adding one of polyvinyl pyrrolidones and a polyethylene glycol, which has a ratio of 0.01 to 0.25 mol with respect to 1 mol of the PZT precursor, to the re-refluxed synthetic solution to be uniformly dispersed in the synthetic solution. In the method according to the invention, since the amount of the one of the polyvinyl pyrrolidones and the polyethylene glycol is decreased by appropriate hydrolysis, a composition capable of simplifying a high-temperature process during film formation and improving production efficiency can be obtained.

In the method of preparing a PZT-based ferroelectric thin film-forming composition according to the fourth aspect of the invention, since one of a propylene glycol and an ethylene glycol is used as the diol, a composition which has a high viscosity and is superior used to form a thick film can be obtained.

The method of forming a PZT-based ferroelectric thin film according to the fifth aspect of the invention includes: coating the PZT-based ferroelectric thin film-forming composition according to the first or second aspect or a PZT-based ferroelectric thin film-forming composition prepared using the method according to the third or fourth aspect on a lower electrode of a substrate; pre-baking the composition; and then baking the composition to be crystallized and to form a thin film on the lower electrode. In this method, the above-described PZT-based ferroelectric thin film-forming composition according to the invention or a PZT-based ferroelectric thin film-forming composition prepared using the above-described method according to the invention is used. Therefore, even when the thickness of a thin film formed for each coating process is greater than or equal to several hundreds of nanometers, a ferroelectric thin film having an extremely small amount of cracks and superior electrical properties can be formed. Further, since the amount of polyvinyl pyrrolidone or polyethylene glycol in the composition used in the method is relatively small, a high-temperature process during film formation can be simplified, and production efficiency can be improved. In addition, since this method easily promotes the densification of a film structure, production efficiency can be increased.

The thin film capacitor or the like according to the sixth aspect of the invention includes a PZT-based ferroelectric thin film which is formed using the above-described method according to the invention and has an extremely small amount of cracks and a dense structure. As a result, the electrical properties and the service life reliability are superior.

BRIEF DESCRIPTION OF THE DRAWINGS

FIG 1 is an image obtained by observing a surface of a PZT-based ferroelectric thin film obtained in Example 1-3 with a scanning electron microscope (SEM).

FIG. 2 is an image obtained by observing a cross-section of the PZT-based ferroelectric thin film obtained in Example 1-3 with an SEM.

FIG 3 is an image obtained by observing a surface of a PZT-based ferroelectric thin film obtained in Comparative Example 1-2 with an SEM.

FIG 4 is an image obtained by observing a cross-section of the PZT-based ferroelectric thin film obtained in Comparative Example 1-2 with an SEM.

FIG 5 is a graph illustrating an example of a temperature profile in a high-temperature process during the formation of a thin film according to an embodiment of the invention.

DETAILED DESCRIPTION OF THE INVENTION

Hereinafter, embodiments of the invention will be described based on the drawings.

A composition according to an embodiment of the invention is an improvement of a composition used to form a PZT-based ferroelectric thin film. As a characteristic configuration, the composition includes: a PZT precursor; a diol; one of polyvinyl pyrrolidones and a polyethylene glycol; and water, in which a ratio of the PZT precursor to 100 wt% of the composition is 17 to 35 wt% in terms of oxides, a ratio of the diol to 100 wt% of the composition is 16 to 56 wt%, a ratio of the one of the polyvinyl pyrrolidones and the polyethylene glycol to 1 mol of the PZT precursor is 0.01 to 0.25 mol in terms of monomers, a ratio of the water to 1 mol of the PZT precursor is 0.5 to 3 mol, and the composition does not further contain a linear monoalcohol having 6 to 12 carbon chains which has a ratio of 0.6 to 10 wt% with respect to 100 wt% of the composition.

APZT-based ferroelectric thin film formed of the composition according to the embodiment is configured by a Pb-containing composite metal oxide having a perovskite structure such as lead zirconate titanate (PZT) or PLZT obtained by adding La to PZT. The PZT precursor contained in the composition is a raw material used to form the above-described composite metal oxide or the like in the formed ferroelectric thin film, and this PZT precursor is contained in the composition such that a desired metal atomic ratio is obtained in PZT or PLZT. Specifically, when the PZT precursor is represented by the formula "$(Pb_xLa_y)(Zr_zTi_{1-z})O_3$", it is preferable that the metal atomic ratio be adjusted such that x, y, and z satisfy $1.00 < x < 1.25$, $0 \leq y \leq 0.05$, and $0.4 < z < 0.6$, respectively. In addition, the PZT-based ferroelectric thin film may also contain, for example, PMnZt to which Mn is added or PNbZT to which Nb is added.

As a material of the PZT precursor, a compound in which an organic group binds to a metal element such as Pb, La, Zr, and Ti through an oxygen or nitrogen atom of the organic group is preferable. Examples of such a compound include one or two or more elements selected from the group consisting of metal alkoxides, metal diol complexes, metal triol complexes, metal carboxylates, metal β-diketonate complexes, metal β-diketoester complexes, metal β-iminoketo complexes, and metal amino complexes. Particularly preferable compounds are metal alkoxides, and partial hydrolysates and organic acid salts thereof.

Specifically, examples of a Pb compound and a La compound include acetates such as lead acetate: $Pb(OAc)_2$ or lanthanum acetate: $La(OAc)_3$; and alkoxides such as lead diisopropoxide: $Pb(OiPr)_2$ or lanthanum triisopropoxide: $La(OiPr)_3$. Examples of a Ti compound include alkoxides such as titanium tetraethoxide: $Ti(OEt)_4$, titanium tetraisopropoxide: $Ti(OiPr)_4$, titanium tetra n-butoxide: $Ti(OnBu)_4$, titanium tetraisobutoxide: $Ti(OiBu)_4$, titanium tetra t-butoxide: $Ti(OtBu)_4$, or titanium dimethoxy diisopropoxide: $Ti(OMe)_2(OiPr)_2$. As a Zr compound, the same alkoxides as those of the Ti compound are preferable. Metal alkoxides may be used without any change, but partial hydrolysates thereof may be used in order to promote decomposition. In addition, examples of a Mn compound include manganese acetate, manganese 2-ethylhexanoate, and manganese naphthenate. In addition, examples of an Nb compound include niobium pentaethoxide and niobium 2-ethylhexanoate.

The reason for limiting the ratio of the PZT precursor to 100 wt% of the composition to be 17 to 35 wt% in terms of oxides is as follows. When the ratio is lower than the lower limit, a sufficient film thickness cannot be obtained. On the other hand, when the ratio is higher than the upper limit, cracking is likely to occur. The ratio of the PZT precursor to 100 wt% of the composition is more preferably 20 to 25 wt% in terms of oxides. The ratio in terms of oxides refers to the ratio of metal oxides to 100 wt% of the composition which is calculated under the assumption that all the metal elements contained in the composition are converted into oxides.

The diol contained in the composition is a component constituting a solvent of the composition. Specific examples of the diol include propylene glycol, ethylene glycol, and 1,3-propanediol. By using the diol as an essential solvent component, the storage stability of the composition can be increased. Among these, propylene glycol or ethylene glycol is preferable from the viewpoints of increasing the storage stability and easily obtaining a composition which has a high viscosity and is superior for forming a thick film.

The reason for limiting the ratio of the diol to 100 wt% of the composition to be 16 to 56 wt% is as follows. When the ratio is lower than the lower limit, precipitates may be formed. On the other hand, when the ratio is higher than the upper limit, voids (micropores) are likely to be formed during the formation of a thick film. The ratio of the diol is more preferably 28 to 42 wt%.

In addition, as other solvents, carboxylic acids, alcohols (for example, ethanol, I-butanol, or polyols other than diol), esters, ketones (such as acetone or methyl ethyl ketone), ethers (such as dimethylether or diethylether), cycloalkanes (such as cyclohexane or cyclohexanol), aromatic compounds (such as benzene, toluene, or xylene) or tetrahydrofuran; or mixed solvents obtained by adding one or two or more of the above-described solvents to diol can be used.

Preferable examples of carboxylic acids include n-butyric acid, α-methylbutyric acid, i-valeric acid, 2-ethylbutyric acid, 2,2-dimethylbutyric acid, 3,3-dimethylbutyric acid, 2,3-dimethylbutyric acid, 3-methylpentanoic acid, 4-methylpentanoic acid, 2-ethylpentanoic acid, 3-ethylpentanoic acid, 2,2-dimethylpentanoic acid, 3,3-dimethylpentanoic acid, 2,3-dimethylpentanoic acid, 2-ethylhexanoic acid, and 3-ethylhexanoic acid.

In addition, preferable examples of esters include ethyl acetate, propyl acetate, n-butyl acetate, sec-butyl acetate, tert-butyl acetate, isobutyl acetate, n-amyl acetate, sec-amyl acetate, tert-amyl acetate and isoamyl acetate. Preferable examples of alcohols include 1-propanol, 2-propanol, 1-butanol, 2-butanol, isobutyl alcohol, 1-pentanol, 2-pentanol, 2-methyl-2-pentanol, and 2-methoxyethanol.

In addition, the composition according to the embodiment contains, as a high-molecular compound, one of polyvinyl pyrrolidones and a polyethylene glycol. Polyvinyl pyrrolidone or polyethylene glycol are used for adjusting the viscosity of the solution in the composition. Polyvinyl pyrrolidone can determine and adjust a relative viscosity based on a k value. "k value" described herein refers to a value representing a viscosity property, which correlates to a molecular weight, and is calculated according to the following Fikentscher's formula using a relative viscosity (25°C) which is measured with a capillary viscometer.

$$k \text{ value} = (1.5 \log\eta\text{rel} - 1)/(0.15 + 0.003c)$$

$$+ (300c \log\eta\text{rel} + (c + 1.5c \log\eta\text{rel})^2)^{1/2}/(0.15c + 0.003c^2)$$

In the above formula, "ηrel" represents a relative viscosity of an aqueous polyvinyl pyrrolidone solution to water, and "c" represents a concentration (wt%) of polyvinyl pyrrolidone in an aqueous polyvinyl pyrrolidone solution.

The k value of polyvinyl pyrrolidone contained in the composition according to the embodiment is preferably 30 to 90. In order to form a thick ferroelectric thin film, when the composition is coated on a substrate or the like, a sufficient viscosity is necessary for maintaining the thickness of the coated coating film (gel film). However, when the k value is lower than the lower limit, it is difficult to obtain the sufficient viscosity. On the other hand, when the k value is higher than the upper limit, the viscosity is excessively high, and it is difficult to uniformly coat the composition. In addition, when polyethylene glycol is used, the polymerization degree thereof is preferably 200 to 400. When the polymerization degree is lower than the lower limit, it is difficult to obtain the sufficient viscosity. On the other hand, when the polymerization degree is higher than the upper limit, the viscosity is excessively high, and it is difficult to uniformly coat the composition. In addition, polyvinyl pyrrolidone is particularly preferable due to an effect of suppressing cracking.

The reason for limiting the ratio of the one of the polyvinyl pyrrolidones and the polyethylene glycol to 1 mol of the PZT precursor to be 0.01 to 0.25 mol in terms of monomers is as follows. When the ratio is lower than the lower limit, cracking is likely to occur. On the other hand, when the ratio is higher than the upper limit, voids are likely to be formed. The ratio of the one of the polyvinyl pyrrolidones and the polyethylene glycol to 1 mol of the PZT precursor is more preferably 0.025 to 0.075 mol. The polyvinyl pyrrolidones (PVP) and the polyethylene glycol have a high decomposition temperature and high affinity to the PZT precursor and thus is difficult to remove from a film, which is likely to cause voids. Therefore, the smaller the addition amount, the better. In the composition according to the embodiment, since organic materials are easily removed from a film by adding a predetermined amount of water to the precursor to be appropriately hydrolyzed, the addition amount of the one of the polyvinyl pyrrolidones and the polyethylene glycol can be suppressed to be relatively low.

The value of "mol in terms of monomers" refers to the value of molecular weight using a monomer included in a high-molecular compound as a reference. The "mol in terms of monomers" to 1 mol of the PZT precursor refers to the ratio of molecular weight to 1 mol of the PZT precursor using a monomer included in a high-molecular compound as a reference.

In addition, examples of water contained in the composition according to the embodiment include ion exchange water and ultrapure water. By the composition containing water at the predetermined ratio, the precursor is appropriately hydrolyzed, and thus an effect of improving the densification of a film structure can be obtained.

The reason for limiting the ratio of water to 1 mol of the PZT precursor to be 0.5 to 3 mol is as follows. When the ratio is lower than the lower limit, hydrolysis is not sufficient, which may cause a problem of insufficient densification of a film structure or the like. On the other hand, when the ratio is higher than the upper limit, hydrolysis is excessively progressed, which may cause a problem of precipitates, cracking in a film, or the like. The ratio of water to 1 mol of the PZT precursor is more preferably 0.8 to 2 mol.

In addition to the above-described components, a stabilizer may be optionally added to the composition at a ratio (number of molecules of stabilizer)/(number of metal atoms) of about 0.2 to 3. Examples of the stabilizer include β-diketones (such as acetyl acetone, heptafluorobutanoyl pivaloyl methane, dipivaloyl methane, trifluoroacetyl acetone, or benzoyl acetone), β-ketonic acids (such as acetoacetic acid, propionyl acetic acid, or benzoyl acetic acid), β-keto esters (such as methyl, propyl, butyl, and other lower alkyl esters of the above-described ketonic acids), oxy acids (such as lactic acid, glycolic acid, α-oxybutyric acid, or salicylic acid), lower alkyl esters of the above-described oxy acids, oxyketones (such as diacetone alcohol or acetoin), diols, triols, higher carboxylic acids, alkanol amines (such as diethanolamine, triethanolamine, or monoethanolamine), and polyvalent amines. Among these, acetyl acetone of β-diketones is preferable as the stabilizer.

In addition, the composition according to the embodiment can contain a polar solvent such as a formamide-based solvent as an organic dopant. As the formamide-based solvent, any of formamide, N-methyl formamide, or N-N-dimethyl formamide is preferably used. In the composition according to the embodiment, since the PZT precursor is hydrolyzed, a thick film having a small amount of cracks can be formed without the addition of the formamide-based solvent or the like. On the other hand, by using the formamide-based solvent or the like in combination with the polyvinyl pyrrolidone and the like, a film having a smaller amount of cracks and a dense structure can be formed. In addition, when the composition is coated, a more uniform coating film can be formed, and an effect of promoting the removal of a solvent during baking can be further improved. Examples of an organic dopant other than the formamide-based solvent include an ethanolamines such as monoethanolamine or diethanolamine, and the ethanolamines can be used in combination with the formamide-based solvent. The ethanolamines has an effect of increasing the storage stability of the solution by being coordinated to a metal alkoxide. The ratio of the organic dopant containing the formamide-based solvent to 100 wt% of the composition is preferably 3 to 13 wt%.

Next, a method of preparing a PZT-based ferroelectric thin film-forming composition according to an embodiment of the invention will be described. First, the above-described Pb compound and the like of the PZT precursor are prepared and weighed at ratios for obtaining the desired metal atomic ratio, respectively. The weighed PZT precursor and a diol are poured into a reaction vessel, if needed, along with a stabilizer such as acetyl acetone and mixed with each other, followed by reflux and reaction, preferably, in a nitrogen atmosphere at a temperature of 130 to 175°C for 0.5 to 3 hours. As a result, a synthetic solution is prepared. After reflux, it is preferable that a solvent be removed using a method such as atmospheric distillation or distillation under reduced pressure. Next, by being left to stand at room temperature, the synthetic solution is cooled to preferably 0 to 50°C and more preferably 0 to 10°C.

The diol is added to the cooled synthetic solution to adjust the concentration, and water which has a ratio of 0.5 mol to 3 mol with respect to 1 mol of the PZT precursor is added thereto, followed by re-reflux, preferably, in a nitrogen atmosphere at a temperature of 100 to 175°C for 0.5 to 10 hours. In this case, it is preferable that the solvent be removed using the above-described method. Next, another solvent such as alcohol is added to the synthetic solution, followed by stirring to dilute the synthetic solution. As a result, the ratio of the PZT precursor to 100 wt% of the prepared composition is adjusted to be 17 to 35 wt% in terms of oxides, and the ratio of the diol to 100 wt% of the composition is adjusted to be 16 to 56 wt%. When an organic dopant containing a formamide-based solvent is added, it is preferable that the organic dopant be added along with other solvents such as alcohol.

Next, one of the polyvinyl pyrrolidones and the polyethylene glycol, which has a ratio of 0.01 to 0.25 mol with respect to 1 mol of the PZT precursor in terms of monomers, is added to the synthetic solution to be uniformly dispersed in the synthetic solution. As a result, the PZT-based ferroelectric thin film-forming composition according to the embodiment is obtained.

After the preparation of the composition, it is preferable that particles be removed from the composition by filtration or the like such that the number of particles having a particle size of 0.5 $\mu$m or greater (preferably 0.3 $\mu$m or greater and more preferably 0.2 $\mu$m or greater) be less than or equal to 50 particles per 1 mL of the composition. When the number of particles having a particle size of 0.5 $\mu$m or greater in the composition is more than 50 particles per 1 mL of the composition, long-term storage stability deteriorates. The fewer number of particles having a particle size of 0.5 $\mu$m or greater in the composition, the better. In particular, the number of particles is preferably less than or equal to 30 particles per 1 mL of the composition.

A method of treating the prepared composition such that the number of particles is in the above-described range is not particularly limited. For example, the following method may be used. A first method is a filtration method of supplying pressure with a syringe using a commercially available membrane filter having a pore size of 0.2 $\mu$m. A second method is a pressure filtration method in which a commercially available membrane filter having a pore size of 0.05 $\mu$m is combined with a pressure tank. A third method is a circulation filtration method in which the filter used in the second method is combined with a solution circulating tank.

In all the methods, a particle capture rate by the filter varies depending on a supply pressure of the composition. It is generally known that, the lower the pressure, the higher the capture rate. Particularly in the first method or the second method, in order to realize the condition that the number of particles having a particle size of 0.5 $\mu$m or greater is less than or equal to 50 particles per 1 mL of the composition, it is preferable that the composition be made to pass extremely slowly through the filter at a low pressure.

A method of forming a PZT-based ferroelectric thin film according to an embodiment of the invention will be described. This forming method is a method of forming a ferroelectric thin film using a sol-gel method. As a raw material solution, the above-described PZT-based ferroelectric thin film-forming composition according to the embodiment or a PZT-based ferroelectric thin film-forming composition prepared using the above-described method according to the embodiment is used.

First, the PZT-based ferroelectric thin film-forming composition is coated on a substrate to form a coating film (gel film) having a desired thickness. The coating method is not particularly limited, and examples thereof include spin coating, dip coating, liquid source misted chemical deposition (LSMCD), and electrostatic spray coating. As a substrate for forming a ferroelectric thin film, different substrates are used according to the uses thereof. For example, when a dielectric layer of a thin film capacitor or the like is formed, a heat-resistant substrate, such as a silicon substrate or a sapphire substrate, on which a lower electrode is formed is used. The lower electrode which is formed on the substrate is formed of a material, such as Pt, Ir, or Ru, which has conductivity and is not reactive with the ferroelectric thin film. In addition, for example, a substrate on which a lower electrode is formed with an adhesion layer, an insulating film, and the like interposed therebetween can be used. Specific examples of the substrate include substrates having a laminate structure (lower electrode/adhesion layer/insulating film/substrate) of P/Ti/SiO$_2$/Si, Pt/TiO$_2$/SiO$_2$/Si, Pt/IrO/Ir/SiO$_2$/Si, Pt/TiN/SiO$_2$/Si, Pt/Ta/SiO$_2$/Si, or Pt/Ir/SiO$_2$/Si. On the other hand, in a piezoelectric element, a pyroelectric infrared detecting element, or the like, a heat-resistant substrate such as a silicon substrate, a SiO$_2$/Si substrate, or a sapphire substrate can be used.

After the coating film is formed on the substrate, this coating film is pre-baked and then baked to be crystallized. Pre-baking is performed using a hot plate or RTA under a predetermined condition. It is preferable that pre-baking be performed in the air, in an oxygen atmosphere or in a water vapor-containing atmosphere in order to remove a solvent and to thermally decompose or hydrolyze a metal compound to be transformed into a complex oxide. Even during heating in the air, moisture required for hydrolysis is sufficiently secured with moisture in the air. Before pre-baking, particularly in order to remove a low-boiling-point solvent or adsorbed water molecules, a low-temperature heating may be performed using a hot plate at a temperature of 70 to 90°C for 0.5 to 5 minutes.

For the purpose of sufficiently removing a solvent and the like to further enhance the effect of suppressing cracks or promoting the densification of a film structure, two-stage pre-baking can be performed while changing a temperature increase rate and a heating holding temperature. However, in the composition used in this forming method, as described above, the amount of polyvinyl pyrrolidone and the like added is small, and a gel from which organic materials can be easily removed is formed. Therefore, even when a relatively thick coating film is pre-baked, one-stage pre-baking can be performed, and thus production efficiency is high. When one-stage pre-baking is performed, it is preferable that the temperature be 400 to 500°C; and that the holding time at the temperature be 1 to 5 minutes. In addition, the composition to be used has a high effect of suppressing cracking in spite that the amount of polyvinyl pyrrolidone and the like added is small. Therefore, even when a relatively thick coating film is pre-baked, it is not necessary that the temperature increase rate be greatly decreased, and production efficiency is high. The temperature increase rate from a temperature, in a range from room temperature to 200°C, to the pre-baking temperature is preferably 10 to 100°C/sec.

In addition, the coating process of the composition to the pre-baking process can be repeated multiple times until a film having a predetermined thickness is obtained, and, finally, baking can be performed in a batch process. In this forming method, the above-described composition according to the embodiment and the like are used as the raw material solution. Therefore, since a thick film having several hundreds of nanometers can be formed for each coating process, the number of the repeated processes can be reduced:

Baking is the process for baking the pre-baked coating film at a crystallization temperature or higher to be crystallized. As a result, a ferroelectric thin film is obtained. As a baking atmosphere in this crystallization process, $O_2$, $N_2$, Ar, $N_2O$, $H_2$, or a mixed gas thereof is preferable. Baking is performed at 600 to 700°C for 1 to 5 minutes. Baking may be performed by rapid thermal annealing (RTA). When baking is performed by RTA, a temperature increase rate thereof is preferably 2.5 to 100°C/sec.

Through the above-described processes, the PZT-based ferroelectric thin film is obtained. In this ferroelectric thin film, the number of processes during film formation is small. Moreover, in spite that the thick film is relatively simply obtained, the amount of cracks is extremely small, and a dense film structure is obtained. Therefore, electrical properties are extremely superior.

Accordingly, the PZT-based ferroelectric thin film obtained using the above-described method according to the embodiment can be desirably used as a constituent material of a composite electronic component such as a thin film capacitor, a capacitor, an IPD, a DRAM memory capacitor, a laminated capacitor, a gate insulator of a transistor, a non-volatile memory, a pyroelectric infrared detecting element, a piezoelectric element, an electro-optic element, an actuator, a resonator, an ultrasonic motor, an electric switch, an optical switch, or an LC noise filter element.

Examples

Next, Examples of the invention and Comparative Examples will be described in detail.

Example 1-1

First, as the PZT precursor, lead acetate trihydrate (Pb source), tetratitanium isopropoxide (Ti source), and tetrazirconium butoxide (Zr source) were weighed such that a metal atomic ratio (Pb/Zr/Ti) was 115/52/48. These materials were added to propylene glycol and acetyl acetone in a reaction vessel to prepare a synthetic solution. After the synthetic solution was refluxed in a nitrogen atmosphere at a temperature of 150°C for 60 min, the solvent was removed from the synthetic solution by distillation under reduced pressure.

Next, by being left to stand at room temperature, the synthetic solution was cooled to 40°C, and propylene glycol was added to dilute the synthetic solution such that the concentration of the PZT precursor was 35 wt% in terms of oxides. 2 mol of ultrapure water with respect to I mol of the PZT precursor was added to the synthetic solution, followed by re-reflux in a nitrogen atmosphere at a temperature of 150°C for 60 minutes. Then, the solvent was removed by distillation under reduced pressure.

Ethanol and N-methyl formamide were added to the synthetic solution subjected to the addition of water, the re-reflux, and the solvent removal, to dilute the synthetic solution such that the concentration of the PZT precursor was 25 wt% in terms of oxides. Further, 0.075 mol of polyvinyl pyrrolidone (k value=30) with respect to 1 mol of the PZT precursor was added to the synthetic solution, followed by stirring at a temperature of 25°C for 24 hours. As a result, a composition for forming a PZT ferroelectric thin film was obtained. This composition was filtered through a commercially available membrane filter having a pore size of 0.05 $\mu$m by supplying a pressure thereto with a syringe. The number of particles having a particle size of 0.5 $\mu$m or greater was 3 particles per 1 mL of the solution.

The obtained composition was dripped on a Pt film (lower electrode) of a Pt/$TiO_2$/$SiO_2$/Si substrate which was set on a spin coater, followed by spin-coating at a rotating speed of 2500 rpm for 60 seconds. As a result, a coating film (gel film) was formed on the substrate.

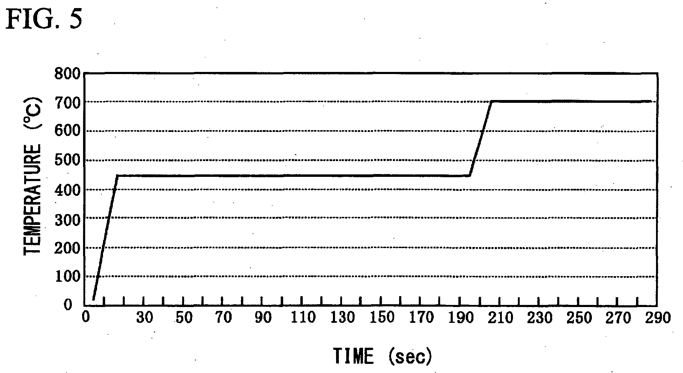

Next, the coating film which was formed on the substrate was pre-baked and baked according to a temperature profile illustrated in FIG 5. As a result, a PZT ferroelectric thin film was formed. Specifically, first, before pre-baking and baking, the substrate on which the coating film was formed was held in the air at a temperature of 75°C for 1 minute using a hot plate. As a result, a low-boiling-point solvent and adsorbed water molecules were removed. Further, for thermal decomposition, using a hot plate, the substrate was held in the air at 300°C for 5 minutes.

Next, as illustrated in FIG 5, using RTA, in an oxygen atmosphere, the coating film was pre-baked by being heated from room temperature to 450°C at a temperature increase rate of 30°C/sec and being held at this temperature for 3 minutes, and then was baked by being heated to 700°C at a temperature increase rate of 30°C/sec and being held at this temperature for 1 minutes. As a result, a PZT ferroelectric thin film was formed on the lower electrode of the substrate. By repeating the processes from the formation of the coating film to pre-baking twice and performing baking once, a film having a desired total thickness was formed.

Examples 1-2 to 1-4 and Comparative Examples 1-1 and 1-2

Compositions were prepared with the same method as that of Example 1-1, except that the amount of polyvinyl pyrrolidone added with respect to 1 mol of the PZT precursor; and the ratio of the diol to 100 wt% of the prepared composition were changed as shown in Table 1 below. Using these compositions, PZT ferroelectric thin films were formed.

Examples 2-1 to 2-3 and Comparative Examples 2-1 and 2-2

Compositions were prepared with the same method as that of Example 1-1, except that the ratio of the PZT precursor in terms of oxides and the ratio of the diol to 100 wt% of the prepared composition; and the amount of polyvinyl pyrrolidone added with respect to 1 mol of the PZT precursor were changed as shown in Table 1 below. Using these compositions, PZT ferroelectric thin films were formed.

Examples 3-1 to 3-3 and Comparative Examples 3-1 and 3-2

Compositions were prepared with the same method as that of Example 1-1, except that the amount of the diol added with respect to 100 wt% of the prepared composition; and the amount of polyvinyl pyrrolidone added with respect to 1 mol of the PZT precursor were changed as shown in Table 1 below. Using these compositions, PZT ferroelectric thin films were formed.

Examples 4-1 to 4-3 and Comparative Examples 4-1 and 4-2

Compositions were prepared with the same method as that of Example 1-1, except that the amount of ultrapure water added and the amount of polyvinyl pyrrolidone added with respect to 1 mol of the PZT precursor; and the amount of the diol added with respect to 100 wt% of the prepared composition were changed as shown in Table 1 below. Using these compositions, PZT ferroelectric thin films were formed.

Example 5

A composition was prepared with the same method as that of Example 1-2, except that N-methyl formamide was not added. Using this composition, a PZT ferroelectric thin film was formed.

Comparative Test and Evaluation

Regarding each of the PZT ferroelectric thin films formed in Examples 1-1 to 5 and Comparative Examples 1-1 to 4-2, the film thickness, the film structure (whether or not cracking occurred, whether or not micropores were formed), and the electrical properties (relative dielectric constant) were evaluated. In addition, the storage stability of the compositions was evaluated. The results were shown in Table 1 below.

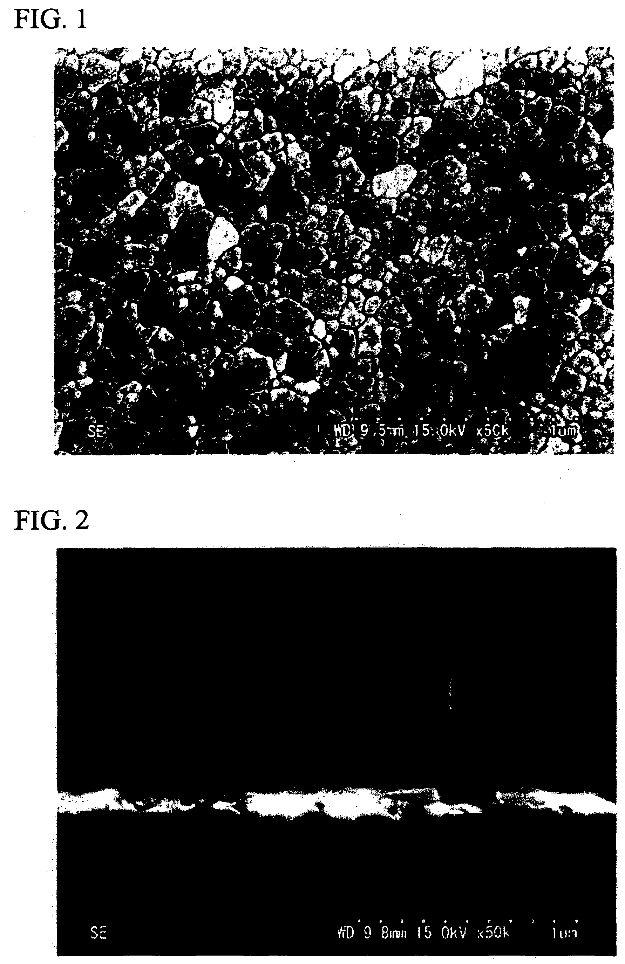

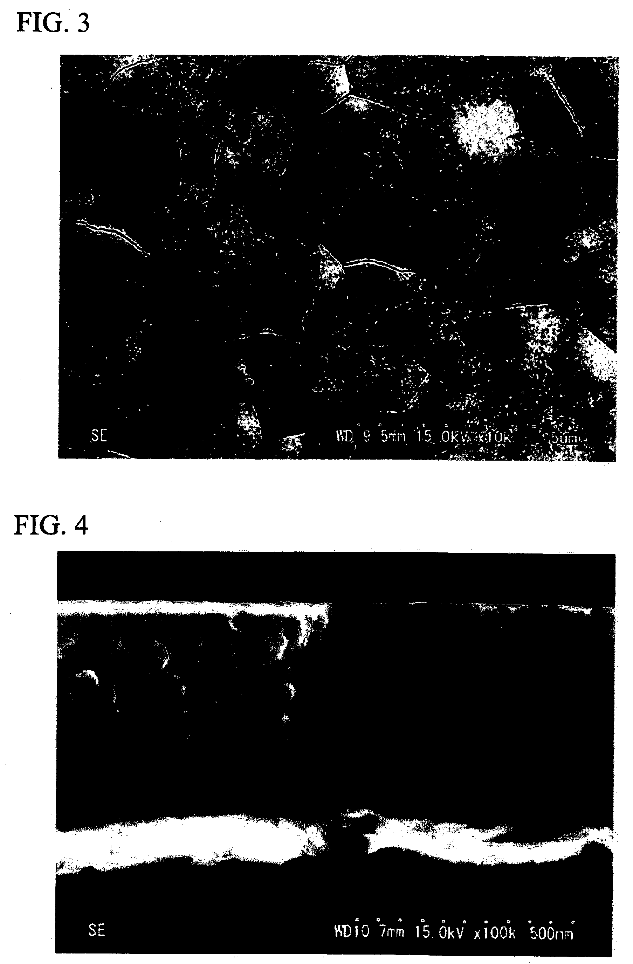

(1) Film Thickness: The thickness (total thickness) of a cross-section of the formed ferroelectric thin film was measured using a spectroscopic ellipsometer (M-2000D1, manufactured by J.A. Woollam Co. Inc.).
(2) Film structure: SEM images of the structures of the surface and the cross-section of the film were observed using the scanning electron microscope used in the thickness measurement. In addition, whether or not cracking occurred and whether or not micropores were formed were determined based on the SEM images. FIGS. 1 and 4 are representative diagrams illustrating the images of the surfaces and the cross-sections of the films of Example 1-3 and Comparative Example 1-2 observed at this time.

(3) Relative dielectric constant: The measurement was performed using a ferroelectric tester (TF-Analyzer 2000, manufactured by aixACCT Systems GmbH). Specifically, an electrode having a size of 200 $\mu$m$\phi$ was formed on a surface of the formed PZT ferroelectric thin film using a sputtering method, and damage recovery annealing was performed by RTA in an oxygen atmosphere at a temperature of 700°C for 1 minute, thereby obtaining a thin film capacitor as a measurement sample. The relative dielectric constant of this thin film capacitor was measured.

(4) Storage stability: The obtained composition was put into a thermostatic chamber at a temperature of 40°C and a humidity of 50%, and whether or not precipitates were formed were checked by visual inspection every 24 hours.

[Table 1]

| | Composition | | | | | Evaluation | | | | |
|---|---|---|---|---|---|---|---|---|---|---|
| | Concentration of Precursor (wt%) | Amount of Diol Added (wt%) | Amount of PVP Added (mol) | Amount of Water Added (mol) | Amount of N-Methyl Formamide Added (wt%) | Storage Stability (Existence of Precipitates) | Film Thickness After Baking (nm) | Cracking | Micropores | Relative Dielectric Constant |
| Ex. 1-1 | 25 | 50 | 0.01 | 2 | 6 | None | 400 | None | None | 1630 |
| Ex. 1-2 | 25 | 37 | 0.15 | 2 | 6 | None | 420 | None | None | 1650 |
| Ex. 1-3 | 25 | 37 | 0.2 | 2 | 6 | None | 480 | None | None | 1590 |
| Ex. 1-4 | 25 | 37 | 0.25 | 2 | 6 | None | 520 | None | Formed in Small Amount | 1480 |
| Comp. Ex. 1-1 | 25 | 56 | - | 2 | 6 | None | 380 | Occurred | None | - |
| Comp. Ex. 1-2 | 25 | 37 | 0.3 | 2 | 6 | None | 540 | None | Formed | 1290 |
| Ex. 2-1 | 17 | 37 | 0.025 | 2 | 6 | None | 380 | None | None | 1620 |
| Ex. 2-2 | 20 | 37 | 0.025 | 2 | 6 | None | 415 | None | None | 1600 |
| Ex. 2-3 | 35 | 37 | 0.025 | 2 | 6 | None | 540 | None | Formed in Small Amount | 1500 |
| Comp. Ex. 2-1 | 15 | 37 | 0.025 | 2 | 6 | None | 330 | Occurred | None | - |
| Comp. Ex. 2-2 | 37 | 37 | 0.025 | 2 | 6 | None | 590 | Occurred | Formed | - |
| Ex. 3-1 | 25 | 16 | 0.025 | 2 | 6 | None | 380 | None | None | 1630 |
| Ex. 3-2 | 25 | 30 | 0.025 | 2 | 6 | None | 400 | None | None | 1670 |
| Ex. 3-3 | 25 | 56 | 0.025 | 2 | 6 | None | 490 | None | None | 1640 |
| Comp. Ex. 3-1 | 25 | 14 | 0.025 | 2 | 6 | Formed | 350 | None | None | 1600 |

(continued)

| | Composition | | | | | Evaluation | | | | |
|---|---|---|---|---|---|---|---|---|---|---|
| | Concentration of Precursor (wt%) | Amount of Diol Added (wt%) | Amount of PVP Added (mol) | Amount of Water Added (mol) | Amount of N-Methyl Formamide Added (wt%) | Storage Stability (Existence of Precipitates) | Film Thickness After Baking (nm) | Cracking | Micropores | Relative Dielectric Constant |
| Comp. Ex. 3-2 | 25 | 58 | 0.025 | 2 | 6 | None | 570 | None | Formed | 1250 |
| Ex. 4-1 | 25 | 37 | 0.025 | 0.5 | 6 | None | 410 | None | None | 1700 |
| Ex. 4-2 | 25 | 37 | 0.025 | 1.5 | 6 | None | 420 | None | None | 1750 |
| Ex. 4-3 | 25 | 37 | 0.025 | 3 | 6 | None | 420 | None | None | 1620 |
| Comp. Ex. 4-1 | 25 | 37 | 0.025 | 0.4 | 6 | None | 410 | None | Formed | 1350 |
| Comp. Ex. 4-2 | 25 | 37 | 0.025 | 4 | 6 | None | 450 | Occurred | Formed | - |
| Ex.5 | 25 | 37 | 0.15 | 2 | - | None | 500 | None | None | 1450 |

As clearly seen from Table 1, when Examples 1-1 to 1-3 were compared to Comparative Examples 1-1 and 1-2, the following results were obtained. In Comparative Example 1-1 in which the ratio of polyvinyl pyrrolidone to 1 mol of the PZT precursor was lower than 0.01 mol, stress was not sufficiently released, and cracking occurred in the formed thin film. In addition, since cracking occurred, the relative dielectric constant was not able to be accurately measured. On the other hand, in Comparative Example 1-2 in which the amount of polyvinyl pyrrolidone added was greater than 0.25 mol, a crack-free and extremely thick film having a thickness of 270 nm (total thickness: 540 nm/number of coating processes performed: 2 times) was formed in each coating process; however, since a large amount of gas was produced by the decomposition of polyvinyl pyrrolidone, micropores were formed in the formed thin film, and the relative dielectric constant was significantly decreased.

On the other hand, in Examples 1-1 to 1-3, although a very small amount of micropores were formed in Example 1-3, crack-free and extremely thick films having a thickness of 200 to 260 nm were able to be formed in each coating process. In addition, the extremely high relative dielectric constants were obtained. As a result, the production efficiency of a thin film was able to be improved.

FIGS. 1 to 4 were compared to each other. In the surface of the PZT ferroelectric thin film of Comparative Example 1-2, as illustrated in FIG. 3, large crystals of which grains were significantly grown were observed. On the other hand, in the surface of the PZT ferroelectric thin film of Example 1-3, as illustrated in FIG 1, dense crystal grains having a grain size of about 100 nm were observed. In addition, the cross-section of the PZT ferroelectric thin film of Comparative Example 1-2 was porous as illustrated in FIG. 4. On the other hand, the cross-section of the PZT ferroelectric thin film of Example 1-3 had a dense columnar structure as illustrated in FIG. 2. It was found from the results that the PZT ferroelectric thin film of Example 1-3 had an extremely dense structure.

In addition, when Examples 2-1 to 2-3 were compared to Comparative Examples 2-1 and 2-2, the following results were obtained. In Comparative Example 2-1 in which the concentration of the PZT precursor was lower than 17 wt% in terms of oxides, a sufficiently thick film was not able to be formed for each coating process. In addition, cracking occurred in the formed thin film, and thus the relative dielectric constant was not able to be accurately measured. In Comparative Example 2-2 in which the concentration of the PZT precursor was greater than 35 wt% in terms of oxides, cracking occurred in the formed thin film, and thus the relative dielectric constant was not able to be accurately measured. In addition, before organic materials such as propylene glycol were not completely removed from the inside of the film, the thermal decomposition of the film progressed. Therefore, micropores were formed in the formed thin film.

In addition, when Examples 3-1 to 3-3 were compared to Comparative Examples 3-1 and 3-2, the following results were obtained. In Comparative Example 3-1 in which the ratio of the diol was lower than 16 wt%, electrical properties were relatively superior, but the storage stability of the composition was poor. In addition, in Comparative Example 3-2 in which the ratio of the diol was greater than 56 wt%, micropores were formed in the formed thin film, and the relative dielectric constant was significantly decreased.

In addition, when Examples 4-1 to 4-3 were compared to Comparative Examples 4-1 and 4-2, the following results were obtained. In Comparative Example 4-1 in which the ratio of water to 1 mol of the PZT precursor was lower than 0.5 mol, organic materials were not sufficiently removed from the inside of the film, micropores were formed in the formed thin film, and the relative dielectric constant was significantly decreased. In addition, in Comparative Example 4-2 in which the ratio of water to 1 mol of the PZT precursor was higher than 3 mol, hydrolysis excessively progressed in the precursor, cracking occurred in the formed thin film, and the relative dielectric constant was not able to be accurately measured.

On the other hand, in Examples 2-1 to 4-3, similarly to the cases of Examples 1-1 to 1-3, a crack-free and extremely thick film having a high relative dielectric constant was obtained for each coating process. As a result, the production efficiency of a thin film was able to be improved. In addition, when Example 5 was compared to Example 1-2, the following results were obtained. Even in Example 5 in which the formamide-based solvent was not added, although the relatively dielectric constant was slightly lower than that of Example 1-2, cracking was sufficiently suppressed due to the hydrolysis effect, and an extremely thick film having a high relative dielectric constant was obtained. As a result, the production efficiency of a thin film was able to be improved.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

Industrial Applicability

The present invention can be used for manufacturing a composite electronic component such as a thin film capacitor, a capacitor, an IPD, a DRAM memory capacitor, a laminated capacitor, a gate insulator of a transistor, a non-volatile memory, a pyroelectric infrared detecting element, a piezoelectric element, an electro-optic element, an actuator, a resonator, an ultrasonic motor, an electric switch, an optical switch, or an LC noise filter element.

**Claims**

1. APZT-based ferroelectric thin film-forming composition used to form a PZT-based ferroelectric thin film, the composition comprising:

   a PZT precursor;
   a diol;
   one of polyvinyl pyrrolidones and a polyethylene glycol; and
   water,
   wherein a ratio of the PZT precursor in 100 wt% of the composition is 17 wt% to 35 wt% in terms of oxides,
   a ratio of the diol to 100 wt% of the composition is 16 wt% to 56 wt%,
   a ratio of the one of the polyvinyl pyrrolidones and the polyethylene glycol to 1 mol of the PZT precursor is 0.01 to 0.25 mol in terms of monomers,
   a ratio of the water to 1 mol of the PZT precursor is 0.5 to 3 mol, and
   the composition does not further contain a linear monoalcohol having 6 to 12 carbon chains which has a ratio of 0.6 to 10 wt% with respect to 100 wt% of the composition.

2. The PZT-based ferroelectric thin film-forming composition according to claim 1,
   wherein the diol is one of a propylene glycol and an ethylene glycol.

3. A method of preparing a PZT-based ferroelectric thin film-forming composition, the method comprising:

   a step of mixing a PZT precursor which has a ratio of 17 wt% to 35 wt% in terms of oxides with respect to 100 wt% of the composition, and a diol which has a ratio of 16 to 56 wt% with respect to 100 wt% of the composition to react with each other to prepare a synthetic solution;
   a step of refluxing the synthetic solution at a temperature of 130 to 175°C for 0.5 to 3 hours;
   a step of cooling the refluxed synthetic solution to 0 to 50°C, adding water, which has a ratio of 0.5 to 3 mol with respect to 1 mol of the PZT precursor, to the synthetic solution, and then re-refluxing the synthetic solution at a temperature of 100 to 175°C for 0.5 to 10 hours; and
   a step of adding one of polyvinyl pyrrolidones and a polyethylene glycol which has a ratio of 0.01 to 0.25 mol with respect to 1 mol of the PZT precursor, to the re-refluxed synthetic solution to be uniformly dispersed in the synthetic solution.

4. The method of preparing a PZT-based ferroelectric thin film-forming composition according to claim 3,
   wherein the diol is one of a propylene glycol and an ethylene glycol.

5. A method of forming a PZT-based ferroelectric thin film, the method comprising:

   coating the PZT-based ferroelectric thin film-forming composition according to claim 1 or 2 or a PZT-based ferroelectric thin film-forming composition prepared using the method according to claim 3 or 4 on a lower electrode of a substrate;
   pre-baking the composition; and
   baking the composition to be crystallized and to form a thin film on the lower electrode.

6. A complex electronic component comprising:

   a PZT-based ferroelectric thin film which is formed using the method according to claim 5,

   wherein the complex electronic component is one of a thin film capacitor, a capacitor, an IPD, a DRAM memory capacitor, a laminated capacitor, a gate insulator of a transistor, a non-volatile memory, a pyroelectric infrared detecting element, a piezoelectric element, an electro-optic element, an actuator, a resonator, an ultrasonic motor, an electric switch, an optical switch, and an LC noise filter element.

**Patentansprüche**

1. PZT-basierte ferroelektrische dünnfilmbildende Zusammensetzung, die zur Bildung eines PZT-basierten ferroelektrischen Dünnfilms verwendet wird, wobei die Zusammensetzung umfasst:

   einen PZT-Vorläufer;
   ein Diol;
   eines von Polyvinylpyrrolidonen und einem Polyethylenglykol; und
   Wasser,
   wobei der Anteil des PZT-Vorläufers in 100 Gew.-% der Zusammensetzung 17 Gew.-% bis 35 Gew.-% als Oxide beträgt,
   der Anteil des Diols in 100 Gew.-% der Zusammensetzung 16 Gew.-% bis 56 Gew.-% beträgt,
   das Verhältnis des einen von Polyvinylpyrrolidonen und Polyethylenglykol zu 1 Mol des PZT-Vorläufers 0,01 bis 0,25 Mol als Monomere beträgt,
   das Verhältnis von Wasser zu 1 Mol des PZT-Vorläufers 0,5 bis 3 Mol beträgt, und
   die Zusammensetzung darüber hinaus keinen linearen Monoalkohol mit 6 bis 12 Ketten-Kohlenstoffatomen enthält, welcher einen Anteil von 0,6 bis 10 Gew.-% bezogen auf 100 Gew.-% der Zusammensetzung beträgt.

2. PZT-basierte ferroelektrische dünnfilmbildende Zusammensetzung nach Anspruch 1, wobei das Diol eins von einem Propylenglykol und einem Ethylenglykol ist.

3. Verfahren zur Herstellung einer PZT-basierten ferroelektrischen dünnfilmbildenden Zusammensetzung, wobei das Verfahren umfasst:

   einen Schritt des Mischens eines PZT-Vorläufers, der einen Anteil von 17 Gew.-% bis 35 Gew.-% als Oxide bezogen auf 100 Gew.-% der Zusammensetzung aufweist, und eines Diols, welches einen Anteil von 16 bis 56 Gew.-% bezogen auf 100 Gew.-% der Zusammensetzung aufweist, um miteinander zur Herstellung einer synthetischen Lösung zu reagieren;
   einen Schritt des Erhitzens der synthetischen Lösung unter Rückfluss bei einer Temperatur von 130 bis 175 °C für 0,5 bis 3 Stunden;
   einen Schritt des Kühlens der unter Rückfluss erhitzten synthetischen Lösung auf 0 bis 50°C, der Zugabe von Wasser, welches einen Anteil von 0,5 bis 3 Mol bezogen auf ein Mol des PZT-Vorläufers aufweist, zur synthetischen Lösung, und dann des Erhitzens der synthetischen Lösung unter Rückfluss bei einer Temperatur von 100 bis 175°C für 0,5 bis 10 Stunden; und
   einen Schritt der Zugabe eines von einem Polyvinylporrolidon und einem Polyethylenglykol, welches einen Anteil von 0,01 bis 0,25 Mol bezogen auf 1 Mol des PZT-Vorläufers aufweist, zur erneut unter Rückfluss erhitzten synthetischen Lösung, so dass es gleichmäßig in der synthetischen Lösung dispergiert wird.

4. Verfahren zur Herstellung einer PZT-basierten ferroelektrischen dünnfilmbildenden Zusammensetzung nach Anspruch 3, wobei das Diol eines von einem Propylenglykol und einem Ethylenglykol ist.

5. Verfahren zur Herstellung eines PZT-basierten ferroelektrischen Dünnfilms, wobei das Verfahren umfasst:

   Auftragen der PZT-basierten ferroelektrischen dünnfilmbildenden Zusammensetzung nach Anspruch 1 oder 2 oder einer PZT-basierten ferroelektrischen dünnfilmbildenden Zusammensetzung, die unter Verwendung des Verfahrens nach Anspruch 3 oder 4 hergestellt wurde, auf eine untere Elektrode eines Substrats;
   Vorbacken der Zusammensetzung; und
   Backen der Zusammensetzung zur Kristallisation und zur Bildung eines dünnen Films auf der unteren Elektrode.

6. Komplexe elektronische Komponente, umfassend:

   einen PZT-basierten ferroelektrischen Dünnfilm, der unter Anwendung des Verfahrens nach Anspruch 5 gebildet wurde,

   wobei die komplexe elektronische Komponente eine von einem Dünnfilmkondensator, einem Kondensator, einem IPD, einem DRAM-SpeicherKondensators, einem laminierten Kondensator, einem Gate-Isolator eines Transistors, einem nicht flüchtigen Speicher, einem pyroelektrischen Infrarot-Detektorelement, einem piezoelektrischen Element, einem elektro-optischen Element, einem Aktor, einem Resonator, einem Ultraschallmotor, einem elektrischen Schalter, einem optischen Schalter und einem LC-Rauschfilter-Element ist.

**Revendications**

1. Composition de formation de film mince ferroélectrique à base de PZT utilisée pour former un film mince ferroélectrique à base de PZT, la composition comprenant :

   un précurseur de PZT ;
   un diol ;
   des polyvinylpyrrolidones ou un polyéthylène glycol ; et
   de l'eau,
   où un rapport du précurseur de PZT dans 100% en poids de la composition est de 17% en poids à 35% en poids en termes d'oxydes,
   un rapport du diol pour 100% en poids de la composition est de 16% en poids à 56% en poids,
   un rapport des polyvinylpyrrolidones ou du polyéthylène glycol sur 1 mole du précurseur de PZT est de 0,01 à 0,25 mole en termes de monomères,
   un rapport de l'eau sur 1 mole du précurseur de PZT est de 0,5 à 3 moles, et
   la composition ne contient pas également un monoalcool linéaire ayant 6 à 12 chaînes de carbone qui a un rapport de 0,6 à 10% en poids par rapport à 100% en poids de la composition.

2. Composition de formation de film mince ferroélectrique à base de PZT selon la revendication 1,
   dans laquelle le diol est l'un d'un propylène glycol et d'un éthylène glycol.

3. Procédé de préparation d'une composition de formation de film mince ferroélectrique à base de PZT, le procédé comprenant :

   une étape de mélange d'un précurseur de PZT qui a un rapport de 17% en poids à 35% en poids en termes d'oxydes par rapport à 100% en poids de la composition, et d'un diol qui a un rapport de 16 à 56% en poids par rapport à 100% en poids de la composition pour réagir l'un avec l'autre afin de préparer une solution synthétique ;
   une étape qui consiste à porter à reflux la solution synthétique à une température allant de 130 à 175°C pendant 0,5 à 3 heures ;
   une étape qui consiste à refroidir la solution synthétique portée à reflux jusqu'à une température allant de 0 à 50°C, à ajouter de l'eau, qui a un rapport de 0,5 à 3 moles par rapport à 1 mole du précurseur de PZT, à la solution synthétique, et ensuite à porter à nouveau à reflux la solution synthétique à une température allant de 100 à 175°C pendant 0,5 à 10 heures ; et
   une étape qui consiste à ajouter des polyvinylpyrrolidones ou un polyéthylène glycol, qui a/ont un rapport de 0,01 à 0,25 mole par rapport à 1 mole du précurseur de PZT, à la solution synthétique portée à nouveau à reflux pour être dispersé(es) uniformément dans la solution synthétique.

4. Procédé de préparation d'une composition de formation de film mince ferroélectrique à base de PZT selon la revendication 3,
   dans lequel le diol est l'un d'un propylène glycol et d'un éthylène glycol.

5. Procédé de formation d'un film mince ferroélectrique à base de PZT, le procédé comprenant le fait
   de revêtir une électrode inférieure d'un substrat avec la composition de formation de film mince ferroélectrique à base de PZT selon la revendication 1 ou 2 ou avec une composition de formation de film mince ferroélectrique à base de PZT préparée en utilisant le procédé selon la revendication 3 ou 4 ;
   de précuire la composition ; et
   de cuire la composition pour être cristallisée et pour former un film mince sur l'électrode inférieure.

6. Composant électronique complexe comprenant :

   un film mince ferroélectrique à base de PZT qui est formé en utilisant le procédé selon la revendication 5,

   dans lequel le composant électronique complexe est l'un(e) d'un condensateur à film mince, d'un condensateur, d'un IPD, d'un condensateur de mémoire DRAM, d'un condensateur stratifié, d'un isolant de grille d'un transistor, d'une mémoire non volatile, d'un élément de détection infrarouge pyroélectrique, d'un élément piézoélectrique, d'un élément électro-optique, d'un actionneur, d'un résonateur, d'un moteur à ultrasons, d'un commutateur électrique, d'un commutateur optique et d'un élément filtre de bruit LC.

## FIG. 1

## FIG. 2

FIG. 3

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013066421 A

- JP 2001261338 A

**Non-patent literature cited in the description**

- *J Sol-Gel Sci Technol,* 2008, vol. 47, 316-325

- *J Sol-Gel Sci Technol,* 2008, vol. 47, 316-325